# EUROPEAN PATENT APPLICATION

(11) **EP 4 646 043 A1**
(43) Date of publication of application: **05.11.2025**
(21) Application number: 24173055.5
(22) Date of filing: 29.04.2024
(51) Int. Cl.: H05K 7/20

(54) **FANS FOR COOLING UNITS**

(71) Applicant: Vertiv S.r.l., 35028 Piove di Sacco, (PD) (IT)
(72) Inventor: MARZOTTO, Stefano, Piove Di Sacco (IT); MASETTO, Filippo, Villanova di Camposampiero (IT); BARBATO, Pierpaolo, Noventa Padovana (IT); FURLAN, Paolo, Monselice (IT)
(74) Representative: Beal, James Michael

(57) **Abstract**

A cooling unit for cooling an enclosed space and a method for cooling an enclosed space are provided. The cooling unit comprises an axial fan and a heat exchanger. The axial fan is configured to receive warm air from a containment region and to direct the warm air towards the heat exchanger. The heat exchanger is configured to cool the warm air and is separated from the axial fan by a separation distance.

## Description

This disclosure relates to a cooling unit for cooling an enclosed space and to a method for cooling an enclosed space.

### Background

In a data centre, servers and other computational equipment can generate a large amount of heat. They typically need to be cooled to prevent overheating, which can otherwise lead to faults or failure. This is important because many industries rely on data centres to operate reliably at all times without interruption. As such, it is necessary for a data centre to maintain efficiency, guarantee data integrity and uphold the trust of customers through providing continuous operation. In data centres, as well as other settings, a cooling unit can remove excess heat from the air in order to cool the air. This helps regulate the environment in which the servers are housed and therefore helps maintain their continuous, efficient operation.

Cooling may be provided by a computer room air conditioner (CRAC) unit and/or by a computer room air handler (CRAH) unit. In CRAC units, warm air is cooled by blowing it over a coil filled with refrigerant. The refrigerant may be kept cool using compression. In contrast, in CRAH units, warm air is cooled by blowing it over a coil filled with chilled water. The chilled water can be supplied from an outside source via one or more pipes, inlets and/or valves. Heat is transferred from the warm air to the refrigerant (in the case of the CRAC units) or to the chilled water (in the case of the CRAH units) before being returned to the space being cooled.

In typical data centres with air-cooled racks, a large proportion of the power consumption is due cooling/electrical ventilation. This power is greater the greater the quantity of air moved, the greater the pressure drop for the distribution of the air, the greater the pressure drop for the exchanger that cools the air, and the lower the efficiency of the fans used. Efforts have been made to reduce this electrical consumption by increasing the exchange surfaces, reducing the pressure drops for distribution and using fans with the highest possible efficiency. However, it would be desirable to continue to reduce the power consumption of cooling units.

Conventionally, a raised floor has been implemented in data centres in order to channel air below the floor. However, this leads to increased cost, complexity and construction time, and may also lead to increased pressure drop. As such, it is desirable to provide cooling compatible with channelling of air flows using other containment means which avoid the need to raise the floor of the data centre.

Cooling or air conditioning in server rooms or technical rooms of data centres can be achieved by using a fan to provide an air flow. Currently, this air flow is provided using centrifugal or radial fans. A radial fan comprises an air intake typically located on the side of the radial fan. Air is drawn into the radial fan via the air intake. An impeller of the radial fan, which may have backwardly curved blades, is driven to rotate, which moves the air in an outwardly radial direction from the centre of the radial fan to be discharged at its outer edges. The radial fan can be used to draw warm air from a hot compartment and push it via a heat exchanger before returning it to the room to be cooled.

Radial fans are used for these implementations because radial fans are known to be capable of providing high static pressure in order to overcome pressure drops inside the radial fan, in the heat exchanger and in the distribution network in the cooled room. For example, a bank of radial fans may be required to process a static pressure higher than 300 Pa, net of local expulsion losses, which is not considered possible to provide with other types of fans.

However, while a radial fan can provide high static pressure, it is able to move only a relatively small volume of air. This means that, in order to supply a specified volume of air per unit of time, a greater number of radial fans are needed. In addition, the change in the direction of the air as it moves through the radial fan leads to a larger pressure drop. These factors result in the operation of the radial fans being less efficient that would be desired. Moreover, since a greater number of individual fans are required, this may lead to increased cost and increased maintenance issues or faults.

In view of the issues discussed above, it would be desirable to provide a cooling unit that operates more efficiently. In addition, it would be desirable to provide a cooling unit with fans that are each able to move a greater volume of air, for example in order to increase the reliability and/or the efficiency of the cooling unit.

The present invention seeks to address these and other disadvantages encountered in the prior art.

### Summary

An invention is set out in the independent claims. Optional features are set out in the dependent claims.

According to an aspect, there is provided a cooling unit for cooling an enclosed space, the cooling unit comprising: an axial fan; and a heat exchanger, wherein the axial fan is configured to receive warm air from a containment region and to direct the warm air towards the heat exchanger, wherein the heat exchanger is configured to cool the warm air and is separated from the axial fan by a separation distance.

According to a further aspect, there is provided a method for cooling an enclosed space using a cooling unit, the method comprising: receiving, by an axial fan of the cooling unit, warm air from a containment region; directing, by the axial fan, the warm air towards a heat exchanger of the cooling unit, wherein the heat exchanger is separated from the axial fan by a separation distance; and cooling, by the heat exchanger, the warm air.

### Brief Description of the Drawings

Specific embodiments are now described, by way of example only, with reference to the drawings, in which:
Figure 1 depicts an example of a cooling unit according to the present disclosure.
Figure 2 depicts another example of a cooling unit according to the present disclosure.
Figure 3 depicts a further example of a cooling unit according to the present disclosure.
Figure 4 depicts an example method for cooling an enclosed space according to the present disclosure.

### Detailed Description

The present disclosure provides a cooling unit for cooling an enclosed space. The cooling unit includes an axial fan and a heat exchanger. The axial fan is configured to receive warm air from a containment region and to direct the warm air towards the heat exchanger. The heat exchanger is configured to cool the warm air and is separated from the axial fan by a separation distance.

An axial fan comprises fan blades which rotate about a central axis of the axial fan. The fan blades extend from the central axis (or close thereto) to an outer edge of the axial fan. Air flows through the axial fan in an axial direction, e.g., parallel to the central axis of the axial fan. Axial fans are known to be able to move large volumes of air. However, this is typically delivered at low pressure such that axial fans have not been thought capable of providing the static pressure needed for implementations in which there are considerable barriers to airflow. In a data centre environment, such barriers may include various containment means, ducting and servers or other computational equipment, which lead to high pressure drop.

The techniques of the present disclosure provide improved implementation of an axial fan into a cooling unit for cooling an enclosed space. The inventors have realised that, through providing a separation distance between the axial fan and the heat exchanger, the axial fan can provide the required static pressure through conversion of dynamic pressure to static pressure over this distance. The total pressure of the air is the sum of its static pressure (the pressure of the air in the absence of its movement) and its dynamic pressure (the pressure associated with the movement of the air). As the air slows down over the separation distance between the fan and the heat exchanger, its dynamic pressure decreases and its static pressure increases by a corresponding amount such that the total pressure is conserved. As such, the arrangement of the axial fan and the heat exchanger according to the present disclosure enables implementation of the axial fan so as to meet the cooling requirements for an enclosed space.

Implementation of an axial fan enables several other benefits to be achieved. In a radial fan, the air changes direction as it passes through the fan, which leads to increased disturbance of the air, increased pressure drop, and lower performance/efficiency. In contrast, in an axial fan, the air flow travels axially and is not forced to change its general direction of flow. This leads to lower pressure drop within the axial fan itself, which also contributes to the ability of the fan to provide the required amount of pressure. Moreover, the axial fan is able to move a larger volume of air than a radial fan, and to provide the required pressure with increased efficiency. Further advantages of the present disclosure will be explained below.

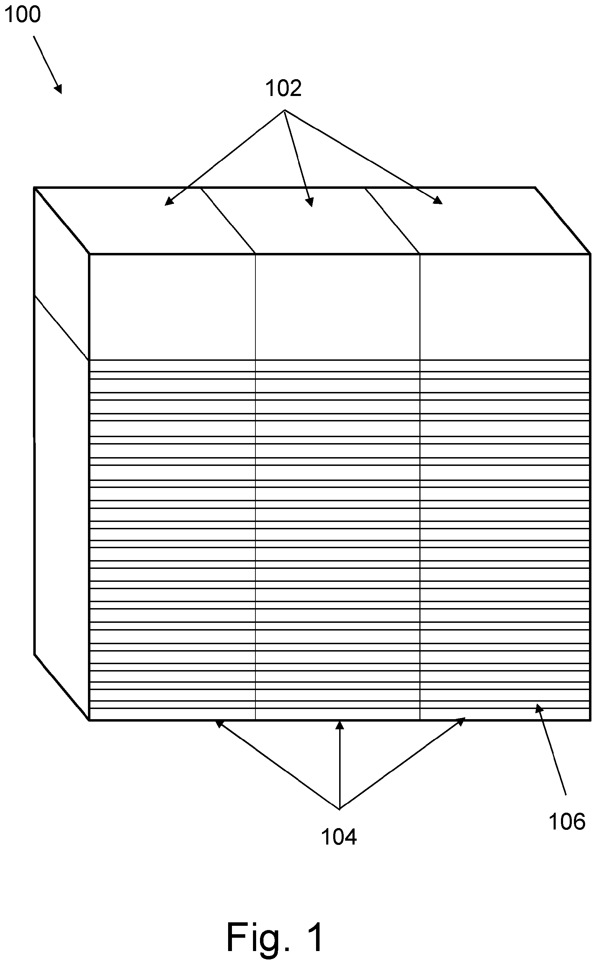

Figure 1 depicts an example of a cooling unit 100 according to the present disclosure. The cooling unit 100 may generally comprise a container or cabinet housing components for transporting and/or cooling air. The cooling unit 100 may be suitable for disposing within a data centre or other room or other enclosed space which requires cooling. The cooling unit 100 may be configured to receive warm air, cool the warm air, and expel cooled air back to the space it is disposed within. The cooling unit 100 may be a CRAH unit. In other examples, the cooling unit 100 may be a CRAC unit.

The cooling unit 100 may comprise one or more fan sections 102. Each of the fan sections 102 may house at least one fan. The fan sections 102 may be disposed at the top of the cooling unit 100. The fans may be completely enclosed by panels and/or safety grids to prevent contact with moving parts of the fan. The grids may allow movement of air therethrough, but prevent large objects or parts of the body from passing therethrough.

The cooling unit 100 may comprise one or more heat exchanger sections 104. Each of the heat exchanger sections 104 may house at least one heat exchanger. As used herein, the heat exchangers may also be referred to as coils and the heat exchanger sections 104 may be referred to as coil sections. The one or more heat exchanger sections 104 may be disposed below the one or more fan sections 102 respectively. The heat exchangers may be enclosed by panels and/or doors for protection against contact with electric components or hot and cold surfaces. At least one of the panels or doors may comprise perforations or slots 106. These are open spaces allowing movement of cooled air from the interior of the heat exchanger sections 104 to the exterior of the heat exchanger sections 104.

The cooling unit 100 may comprise one or more additional components such as an access door for servicing/maintenance, a control panel, a display, a shut-off switch, a power supply and/or hot and cold water connections for supplying cold water to and receiving hot water from the heat exchangers.

In use, the warm air from an enclosed space such as a server room of a data center is conveyed to the cooling unit 100 (e.g. in one or more ducts or pipes) and enters the top of the one or more fan sections 102 of the cooling unit 100. The tops of the fan sections 102 may comprise open areas which allow the warm air to enter, for example may comprise safety grids through which the warm air can pass. The warm air is directed downwards by the fans into the heat exchanger sections 104. The fan sections 102 and the heat exchanger sections 104 may be open to each other with no barriers therebetween in order to avoid restriction of air flow. The air may pass over/through the heat exchangers in the heat exchanger sections 104, which cools the warm air. The cooled air is discharged back into the enclosed space via the perforations or slots 106. This cycle removes warm air from the enclosed space and returns it to the enclosed space after it has been cooled. This extracts heat generated in the enclosed space and cools, or at least prevents excessive heating of, the enclosed space and the components therein.

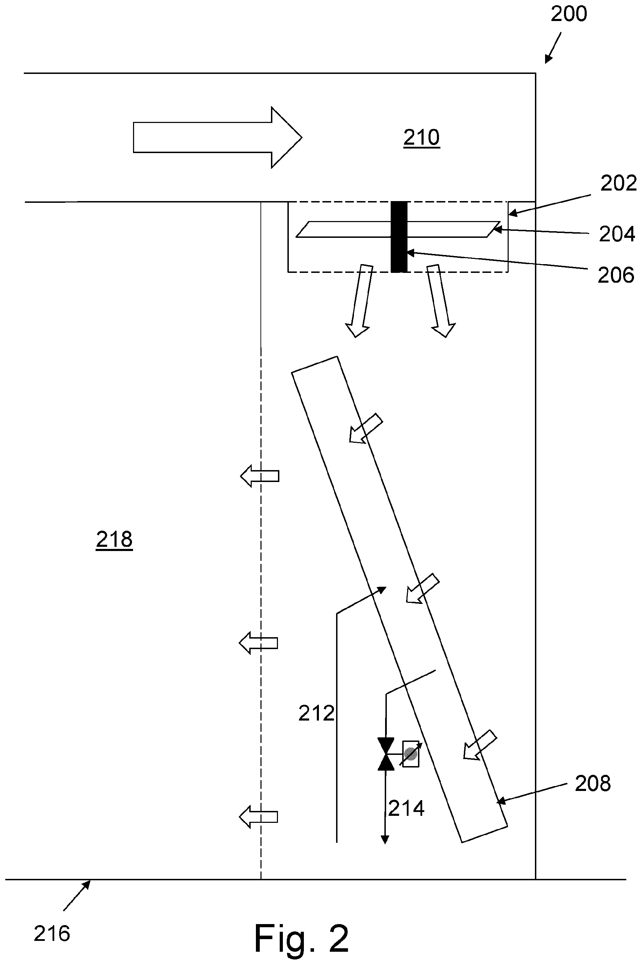

Figure 2 depicts an example of a cooling unit 200 according to the present disclosure. The cooling unit 200 may correspond to the cooling unit 100 described in relation to Figure 1.

The cooling unit 200 comprises an axial fan 202 and a heat exchanger 208. While only a single axial fan 202 and a single heat exchanger 208 are shown in Figure 2, it will be understood that the cooling unit 200 may comprise multiple axial fans 202 and/or multiple heat exchangers 208.

The axial fan 202 comprises fan blades 204 and a central support 206. The fan blades 204 are fixed to the central support 206 and extend towards the outer edge of the axial fan 202. The central support 206 coincides with a central axis of the axial fan 202. The central support 206 is driven to rotate such that the fan blades 204 rotate about the central axis. While two fan blades 204 are depicted in Figure 2, it will be understood that axial fans 202 as described herein may comprise any number of fan blades 204, such as two, three, four, five, six, seven or eight fan blades 204. As the skilled person would understand, the fan blades 204 may comprise any suitable shape and any suitable blade angle depending on the application and desired performance. The fan blades 204 may be flat, inclined, curved or aerofoil shaped. The axial fan 202 may be a propeller fan, tube axial fan or vane axial fan.

In Figure 2, movement of air is depicted using block arrows. Warm air may be received from an enclosed space into a warm containment region 210. The warm containment region 210 may comprise a duct or pipe, and may be disposed above or at the top of the cooling unit 200, for example, adjacent to the ceiling of the enclosed space. The warm containment region 210 may direct the warm air to the axial fan 202, as depicted by the horizontal block arrow at the top of Figure 2. The warm air may move into the axial fan 202. The movement of the blades 204 of the axial fan 202 may create a pressure difference between the top and the bottom of the axial fan 202 as depicted in Figure 2 which draws the warm air into and through the axial fan 202.

The axial fan 202 is arranged/oriented to direct the warm air towards the heat exchanger 208, as depicted in Figure 2 using the two block arrows at the bottom of the axial fan 202. The warm air may pass over/through the heat exchanger 208, as depicted in Figure 2 using the three block arrows directed into the heat exchanger 208. The heat exchanger 208 is configured to cool the warm air and to output cool air to the enclosed space, as depicted in Figure 2 using the three horizontal block arrows. This cool air may be output via the perforations or slots 106 referred to in relation to Figure 1.

The heat exchanger 208 may take any suitable form for extracting heat from the warm air in order to cool the air. The heat exchanger 208 may be a chilled water unit in which heat is transferred from the air into the chilled water. The heat exchanger 208 may comprise a cool water inlet 212 configured to introduce cool water into the heat exchanger 208. As the warm air passes over surfaces of/through the heat exchanger 208, heat from the warm air may be transferred into the cool water. This causes the air to cool down and the water to heat up. The heat exchanger 208 may comprise a warm water outlet 214 configured to remove warm water from the heat exchanger 208. The warm water inlet 212 and/or the cool water outlet may each comprise a respective pipe. The warm water inlet 212 and/or the cool water outlet may each comprise a respective valve configured to control water flow through the heat exchanger 208. As would be understood by the skilled person, such valves may comprise any suitable forms of valve, including two-way valves, three-way valves and pressure independent control valves. In some examples, liquids other than water may be used as the medium for receiving the heat. The heat exchanger 208 may comprise tube fin heat exchangers or microchannel heat exchangers. In some examples, the heat exchanger 208 may be a direct expansion unit.

The cooling unit 200 may be disposed on a floor 216 of the enclosed space. The cooling unit 210 may be particularly suitable for used in a data centre or other enclosed space without a raised floor. For instance, the floor 216 may be described as solid, without ducting enabling substantial air flow below it. Instead, warm air may be introduced into the cooling unit 200 via the warm containment region and may leave the cooling unit 200 via the perforations or slots 106.

A service area 218 is located adjacent to the cooling unit 200. The service area may provide access to the cooling unit 200 in order to service or maintain one or more components thereof, or in order to control the operation thereof (for example via a control panel). In Figure 2, the cooling unit is depicted in a front air delivery arrangement in which the service area is depicted to the left of the cooling unit 200, e.g., to the same side of the cooling unit 200 from which the warm air enters the cooling unit 200.

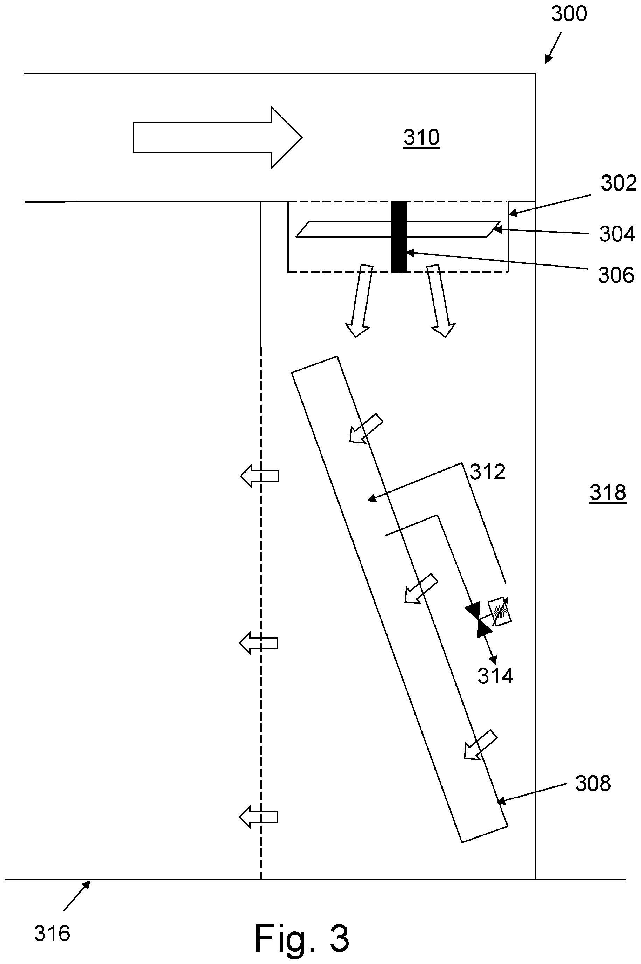

Figure 3 depicts an example of a cooling unit 300 according to the present disclosure. The cooling unit 300 may correspond to the cooling unit 100 described in relation to Figure 1. The cooling unit 300 may generally correspond to the cooling unit 200 described in relation to Figure 2.

While the cooling unit 200 is a front air delivery cooling unit 200, the cooling unit 300 is a back air delivery cooling unit 300. As depicted in Figure 3, the service area 318 is to the right of the cooling unit 300, e.g., to the opposite side of the cooling unit 300 from which the warm air enters the cooling unit 300. In addition, the cool water inlet 312 and the warm water outlet 314 are to the right of the heat exchanger 308, e.g., on the same side as the service area 318. The service area 318, cool water inlet 312 and warm water outlet 314 may otherwise generally correspond to the service area 218, cool water inlet 212 and warm water outlet 214 respectively. The axial fan 302, fan blades 304, central support 306, heat exchanger 308, warm containment region 310 and floor 316 may generally correspond to the axial fan 202, fan blades 204, central support 206, heat exchanger 208, warm containment region 210 and floor 216 respectively.

As shown in Figure 2 (similar comments apply in respect of Figure 3), the heat exchanger 208 is disposed after the axial fan 202 in the air flow cycle. This reverses the order of these components relative to other implementations of heat exchangers and axial fans, in which axial fans are typically placed after heat exchangers.

Typically, CRAH units are designed with the fan after the heat exchanger. Such units were developed for raised floor applications, in which, in order to provide high efficiency, the fan was placed under the floor in order to provide air discharge in a large range of directions. For implementations with no raised floor, it is important to have a uniform air distribution after the heat exchanger/coil and to provide straight air flow at the outlet of the cooling unit. According to the present disclosure, the fan 202 has been arranged before the heat exchanger 208 in the path of the air flowing through the cooling unit 200, e.g., at the suction end of the cooling unit 200. Moreover, according to the present disclosure, an axial fan 202 has been implemented, which avoids radial components.

At the suction end of the cooling unit 200, the warm air is hotter than at the discharge end of the cooling unit 200. There is a trend to operate data centres at higher temperatures as time goes on. This may require use of a larger air flow rate and a lower temperature change in cooling units. The axial fan 202 may be particularly suitable for meeting these requirements, and may be able to work effectively with very high temperatures in which precise air distribution is needed to avoid hot spots.

Since the axial fan 202 is able to manage more air flow than a radial fan, it can operate at a higher return air temperature, granting a wider range of operation of the cooling unit 200. Attempting to achieve this with a radial fan would require increased motor size and increased electricity consumption, which would correspond to an increase in the size of the electrical infrastructure utilised and increased costs.

Moreover, as shown in Figure 2, the axial fan 202 and the heat exchanger 208 are separated by a separation distance. The separation distance may be the distance between the bottom of the axial fan 202 and the top of the heat exchanger 208, e.g., the distance between these components at their closest points. In other examples, the separation distance may be defined as the distance from the centre of the axial fan 202 to the centre of the heat exchanger 208.

Over the separation distance between the axial fan 202 and the heat exchanger 208, there may only be air/free space. For instance, the axial fan 202 and the heat exchanger 208 may be arranged such that the warm air flows from the axial fan 202 to the heat exchanger 208 through air/free space. For instance, there may be no barriers between the axial fan 202 and the heat exchanger 208 components, e.g., no barriers which would substantially affect/reduce the warm air flow from the axial fan 202 to the heat exchanger 208. In other words, an empty chamber or compartment is provided between the axial fan 202 and the heat exchanger 208 for the warm air to pass through. For example, the separation distance is the distance, along the path of the air flow through the cooling unit 200, that the air travels from the axial fan 202 to the heat exchanger 208 when the cooling unit 200 is in use.

Axial fans are typically not considered suitable for implementation in a cooling unit for cooling enclosed spaces, e.g., in which there are considerable barriers to air flow. Such barriers may include various containment means, ducting and servers or other computational equipment, which lead to high pressure drop. Instead, radial fans are typically used for these implementations because radial fans are known to be capable of providing high static pressure in order to overcome pressure drops inside the radial fan and the heat exchanger and arising from the barriers in the enclosed space.

However, the inventors of the present application have determined an arrangement of the cooling unit 200 which enables the axial fan 202 to be suitable for implementations in which enclosed spaces are cooled. The axial fan 202 typically provides relatively low static pressure, which leads to difficulties when there are barriers in the enclosed space/forming the enclosed space which lead to considerable pressure drops.

Air is sucked into the axial fan 202, which leads to an increase in pressure and speed of the air as it passes through the axial fan 202 and leaves the outlet of the axial fan 202 (at the bottom of the axial fan 202 in Figure 2). Bernoulli's principle provides that an increase in the speed of a fluid occurs simultaneously with a decrease in its static pressure or potential energy, and that a decrease in the speed of the fluid occurs simultaneously with an increase in its static pressure or potential energy. According to the present disclosure, the axial fan 202 and the heat exchanger 208 are separated by a separation distance. As the warm air expelled from the axial fan 202 travels over this separation distance, it slows down. As the warm air decreases in speed, there is a corresponding increase in its static pressure. For example, dynamic pressure provided by the axial fan 202 has been converted to static pressure over the separation distance, thereby increasing the static pressure the axial fan 202 is able to provide, for example at the location of the heat exchanger 208. This enables the axial fan 202 to provide enough static pressure for implementation in the cooling unit 200 for cooling an enclosed space because the static pressure provided is enough to overcome the pressure drops resulting from the various barriers to air flow.

For implementations in which there is no raised floor, it is required to have a more uniform distribution of air across the cooling unit 200 in order to avoid radial components at the cooling unit outlet. Accordingly, in the current disclosure, the fan is disposed at the suction end of the cooling unit. This enables a wider discharge surface and lower pressure drop, recovery of static pressure with axial fans since the air speed decreases along the path of the air, and avoidance of radial components at the outlet of the cooling unit 200.

Further aspects of the axial fan 202 further enable its implementation in spaces in which there are considerable barriers to air flow and therefore substantial pressure drops. In a radial fan, the air changes direction as it passes through the fan. In contrast, in the axial fan 202, the air generally travels parallel to the central axis of the axial fan 202, such that there is a lower pressure drop within the axial fan 202 itself. Moreover, relative to radial fans, the axial fan 202 can be installed with a larger diameter. This keeps local speeds lower and reduces turbulence inside the axial fan 202, which further reduces the pressure drop associated with the fan itself. This minimisation of the pressure drop associated with the axial fan 202 itself further enables implementation of the axial fan 202 in enclosed spaces in which there are high pressure drops. For example, the lower pressure drop inside the fan offsets the high pressure drop in the air distribution network.

In the axial fan 202, the air is discharged with only axial components, which avoids there being pressure drops linked to fan installation inside the cabinet of the cooling unit 200. If an impeller of a radial fan is close to obstacles, the radial fan cannot provide the same performance and efficiency as in free air discharge applications. This leads to higher pressure drop, higher energy consumption and lower air flow. For example, if the fan is within a series of obstacles forming a tight box around it then its performance drops such that a radial fan with a smaller diameter would need to be used. This problem is not present with the axial fan 202 in which there is no radial component. Therefore, use of the axial fan 202 enables more space-efficient use of the overall unit intake footprint for the installation, instead of being subject to the above-mentioned constraints on radial fans.

In addition to the above-mentioned air flow benefits of the axial fan 202, implementation of axial fans 202 may have further benefits relative to radial fans. The axial fan 202 is more efficient than a corresponding radial fan, which enables reduced electrical consumption of the cooling unit 200. The axial fan 202 is able to provide a higher maximum flow rate relative to radial fans. Due to this, a smaller number of axial fans may be needed for cooling a particular enclosed space relative to the number of radial fans that would be needed. This reduces costs and can reduce the maintenance or servicing required since there are a smaller number of components to develop faults. For example, three axial fans 202 may be used instead of four radial fans.

The present disclosure is not limited to particular sizes of cooling units or components thereof. As the skilled person would appreciate, these could be adapted according to the intended implementation/particular space or components to be cooled. By way of non-limiting example, a particular implementation of a cooling unit 100, 200, 300 for cooling a data centre may have approximate dimensions of approximately 1m depth, 2.5-3.5m width and 3m high. By way of non-limiting example, the diameter of the axial fans 202 may be approximately 1m.

Different separation distances may be provided depending on the particular implementation, for example depending on the number and extent of barriers present and their associated pressure drop, and thus the static pressure required of the axial fan 202. The larger the separation distance, the better the performance may be. However, there is a trade-off between this and the dimensions/footprint of the cooling unit 200. As such, the separation distance that is used may be selected to be different in different operational contexts based on considerations including the performance required, the efficiency desired, the space available, and the costs that are acceptable.

By way of non-limiting example, the separation distance between the lowermost part of the axial fan 202 (e.g., its outlet) and the uppermost part of the heat exchanger 208 may be approximately 15cm, approximately 18cm, or approximately 25cm. The separation distance may be at least 15cm. The separation distance may be in the range of approximately 15cm to approximately 25cm. The separation distance may be approximately 10cm, approximately 15cm, approximately 20cm, approximately 25cm or approximately 30cm.

The separation distance may be defined relative to a diameter of the axial fan 202, which may correspond to the diameter of the circle swept out by the fan blades 204 of the axial fan 202. For example, the separation distance may be at least 10% of the diameter of the axial fan 202. The separation distance may be between 10% and 50% of the diameter of the diameter of the axial fan 202. The separation distance may be between 20% and 40% of the diameter of the axial fan 202. The separation distance may be approximately 10%, approximately 20%, approximately 30%, approximately 40%, approximately 50%, approximately 60%, approximately 70%, approximately 80%, approximately 90%, or approximately 100% of the diameter of the axial fan 202, or may be larger than the diameter of the axial fan 202.

The axial fan 202 and the heat exchanger 208 may be arranged with a separation distance therebetween such that air is significantly slowed down as it moves between the axial fan 202 and the heat exchanger 208 in order to provide recovery of static pressure. The separation distances described herein are suitable for providing this slowing down of the air and this recovery of static pressure.

The axial fan 202 may be oriented such that its central axis is orientated parallel to a vertical axis, with the axial fan 202 configured to direct warm air vertically downwards. The heat exchanger 208 may be located below the axial fan at an acute angle to the vertical axis. The heat exchanger 208 may be generally cuboid in shape, with a front plane parallel to a back plane (the longer sides of the heat exchanger 208 depicted in Figure 2). This acute angle may be formed between the front plane/back plane and the vertical axis. By way of non-limiting example, this acute angle may be approximately 12°, approximately 13°, approximately 14°, approximately 15°, approximately 16°, approximately 17°, or approximately 18°. In some examples, the acute angle may be approximately 10°, approximately 15°, approximately 20°, approximately 25° or approximately 30°. Water can condensate on surfaces of the heat exchanger 208. This acute angle may advantageously cause this water to remain on these surfaces without getting dragged away by the moving air.

A cooling unit 100, 200, 300 as described herein may comprise any number of axial fans 202 and any number of heat exchangers 208. In some examples, the number of axial fans 202 is equal to the number of heat exchangers 208, with each axial fan 202 being configured to direct warm air to a respective heat exchanger 208. In some examples, the number of axial fans 202 may differ from the number of heat exchangers 208, with each axial fan being configured to direct warm air to multiple respective heat exchangers 208, or each heat exchanger 208 being configured to receive warm air from multiple respective axial fans 202.

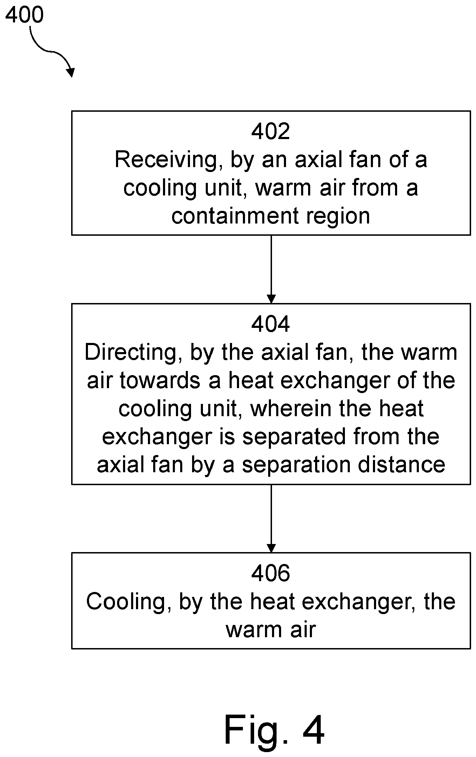

Figure 4 depicts an example method 400 for cooling an enclosed space according to the present disclosure. The method 400 may be performed using any one of the cooling units 100, 200, 300 described above in relation to Figures 1-3.

In step 402, the method may comprise receiving, by an axial fan of the cooling unit, warm air from a containment region.

In step 404, the method may comprise directing, by the axial fan, the warm air towards a heat exchanger of the cooling unit, wherein the heat exchanger is separated from the axial fan by a separation distance.

In step 406, the method may comprise cooling, by the heat exchanger, the warm air.

The axial fan and the heat exchanger of the cooling unit in this method may comprise any of the features and relative arrangements set out herein when describing these components themselves. Similarly, the enclosed space and its relation to the cooling unit in this method may correspond to the enclosed space and its relation to the cooling unit as set out herein when describing these features themselves.

The method may comprise the containment region receiving warm air from the enclosed space, and the containment region may be disposed adjacent to a ceiling of a room comprising the enclosed space. The warm air cooled by the heat exchanger may be described as cool air (having a lower temperature than the warm air), and the heat exchanger may direct the cool air to the enclosed space, for example via one or more perforations in a housing of the cooling unit. In this manner, a cycle of air flow may be established in which servers and other computational equipment in the enclosed space warm the surrounding air, this air is channelled to the cooling unit which cools the air, and the cooling unit returns the cooled air to the enclosed space to once again be warmed by the servers and other computational equipment. The servers and other computational equipment are thus cooled, or at least prevented from becoming excessively warm, by the cooling unit.

While the methods disclosed herein are presented in a certain sequential order, this should not be taken to limit the methods to the orders presented. One or more of the method steps may be omitted or rearranged. The various steps may be performed in different orders. Various steps may be performed at the same time or substantially the same time. Herein, references to events occurring substantially at the same time may refer to events at least partially overlapping in time and/or events occurring at the same time within measurement uncertainties.

The cooling unit described herein may be configured to perform any of the method steps presently disclosed and may comprise computer executable instructions which, when executed by a processor, cause the processor to perform any of the method steps presently disclosed. Any of the steps that the cooling unit is configured to perform may be considered as method steps of the present disclosure and may be embodied in computer executable instructions for execution by a processor. A computer-readable medium (which may be a non-transitory computer-readable medium) may comprise the above-described computer executable instructions.

It is to be understood that the above description is intended to be illustrative, and not restrictive. Many other implementations will be apparent to those of skill in the art upon reading and understanding the above description. Although the present disclosure has been described with reference to specific example implementations, it will be recognized that the disclosure is not limited to the implementations described, but can be practiced with modification and alteration within the scope of the appended claims. Accordingly, the specification and drawings are to be regarded in an illustrative sense rather than a restrictive sense. The scope of the disclosure should, therefore, be determined with reference to the appended claims, along with the full scope of equivalents to which such claims are entitled.

The disclosure comprises the following items:
1. A method for cooling an enclosed space using a cooling unit, the method comprising:
   receiving, by an axial fan of the cooling unit, warm air from a containment region;
   directing, by the axial fan, the warm air towards a heat exchanger of the cooling unit, wherein the heat exchanger is separated from the axial fan by a separation distance; and
   cooling, by the heat exchanger, the warm air.
2. The method according to item 1, comprising:
   receiving, by a fluid inlet of the heat exchanger, cool fluid;
   removing, by a fluid outlet of the heat exchanger, warm fluid from the heat exchanger, wherein at least one pipe joins the fluid inlet to the fluid outlet; and
   cooling, by the heat exchanger, the warm air which passes over the heat exchanger through heat from the warm air being transferred to the cool fluid.
3. The method according to item 2, wherein the cool fluid and the warm fluid comprise a same fluid which changes temperature in the heat exchanger, and wherein the same fluid is water.
4. The method according to any preceding item, wherein the axial fan is disposed above the heat exchanger.
5. A method according to any preceding item, wherein a central axis of the axial fan is aligned with a vertical axis.
6. The method according to item 5, wherein the heat exchanger is disposed at an acute angle to the vertical axis.
7. The method according to any preceding item, wherein the axial fan and the heat exchanger are arranged such that there is a space between the axial fan and the heat exchanger.
8. The method according to any preceding item, wherein there is no barrier impeding air flow between the axial fan and the heat exchanger.
9. The method according to any preceding item, wherein the heat exchanger is separated from the axial fan by a distance of at least 15 cm.
10. The method according to any preceding item, wherein the heat exchanger is separated from the axial fan by a distance in the range of 15 - 25 cm.
11. The method according to any preceding item, the enclosed space comprising one or more ducts and/or one or more components forming a barrier to flow of air within the enclosed space.
12. The method according to any preceding item, wherein the warm air cooled by the heat exchanger is cool air, and wherein the heat exchanger directs the cool air to the enclosed space via one or more perforations in a housing of the cooling unit.
13. The method according to any preceding item, wherein the containment region receives warm air from the enclosed space, the containment region being disposed adjacent to a ceiling of a room comprising the enclosed space.
14. The method according to any preceding item, wherein the axial fan and the heat exchanger are arranged with the separation distance therebetween to such that dynamic pressure provided by the axial fan is converted to static pressure over the separation distance.

## Claims

1. A cooling unit for cooling an enclosed space, the cooling unit comprising:
an axial fan; and
a heat exchanger,
wherein the axial fan is configured to receive warm air from a containment region and to direct the warm air towards the heat exchanger,
wherein the heat exchanger is configured to cool the warm air and is separated from the axial fan by a separation distance.

2. The cooling unit according to claim 1, wherein the heat exchanger comprises:
a fluid inlet configured to receive cool fluid;
a fluid outlet configured to remove warm fluid from the heat exchanger; and
at least one pipe joining the fluid inlet to the fluid outlet,
wherein the heat exchanger is configured to cool the warm air which passes over the heat exchanger through heat from the warm air being transferred to the cool fluid.

3. The cooling unit according to claim 2, wherein the cool fluid and the warm fluid comprise a same fluid, the heat exchanger being configured to change the temperature thereof, and wherein the same fluid is water.

4. The cooling unit according to any preceding claim, wherein the axial fan is disposed above the heat exchanger.

5. The cooling unit according to any preceding claim, wherein a central axis of the axial fan is aligned with a vertical axis.

6. The cooling unit according to claim 5, wherein the heat exchanger is disposed at an acute angle to the vertical axis.

7. The cooling unit according to any preceding claim, wherein the axial fan and the heat exchanger are arranged such that there is a space between the axial fan and the heat exchanger.

8. The cooling unit according to any preceding claim, wherein there is no barrier arranged to impede air flow between the axial fan and the heat exchanger.

9. The cooling unit according to any preceding claim, wherein the heat exchanger is separated from the axial fan by a distance of at least 15 cm.

10. The cooling unit according to any preceding claim, wherein the heat exchanger is separated from the axial fan by a distance in the range of 15 - 25 cm.

11. The cooling unit according to any preceding claim, the enclosed space comprising one or more ducts and/or one or more components forming a barrier to flow of air within the enclosed space.

12. The cooling unit according to any preceding claim, wherein the heat exchanger is configured to direct the cooled air to the enclosed space via one or more perforations in a housing of the cooling unit.

13. The cooling unit according to any preceding claim, wherein the containment region is configured to receive warm air from the enclosed space, the containment region being disposed adjacent to a ceiling of a room comprising the enclosed space.

14. The cooling unit according to any preceding claim, wherein the axial fan and the heat exchanger are arranged with the separation distance therebetween so as to enable dynamic pressure provided by the axial fan to be converted to static pressure over the separation distance.

15. A method for cooling an enclosed space using a cooling unit, the method comprising:
receiving, by an axial fan of the cooling unit, warm air from a containment region;
directing, by the axial fan, the warm air towards a heat exchanger of the cooling unit, wherein the heat exchanger is separated from the axial fan by a separation distance; and
cooling, by the heat exchanger, the warm air.
